(19) Europäisches Patentamt
European Patent Office
Office européen des brevets

(11) **EP 1 867 752 A1**

(12) **EUROPEAN PATENT APPLICATION**
published in accordance with Art. 158(3) EPC

(43) Date of publication:
**19.12.2007 Bulletin 2007/51**

(51) Int Cl.:
**C23C 18/31** *(2006.01)* **C23C 18/20** *(2006.01)*
**B22F 9/18** *(2006.01)*

(21) Application number: **05809388.1**

(22) Date of filing: **22.11.2005**

(86) International application number:
**PCT/JP2005/021446**

(87) International publication number:
**WO 2006/057242 (01.06.2006 Gazette 2006/22)**

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **25.11.2004 JP 2004341274
27.12.2004 JP 2004377507
27.12.2004 JP 2004377508
19.07.2005 JP 2005209253**

(71) Applicant: **Mitsui Chemicals, Inc.
Tokyo 105-7117 (JP)**

(72) Inventors:
• **TAKAHASHI, Masaki
Mitsui Chemicals, Inc.,
Sodegaura-shi, Chiba 299-0265 (JP)**

• **IWATA, Kenji
Mitsui Chemicals, Inc.,
Sodegaura-shi, Chiba 299-0265 (JP)**
• **WATANABE, Hiroshi
Mitsui Chemicals, Inc.,
Sodegaura-shi, Chiba 299-0265 (JP)**
• **GOTO, Kenichi
Mitsui Chemicals, Inc.,
Sodegaura-shi, Chiba 299-0265 (JP)**
• **KAMADA, Jun
Mitsui Chemicals, Inc.,
Sodegaura-shi, Chiba 299-0265 (JP)**

(74) Representative: **HOFFMANN EITLE
Patent- und Rechtsanwälte
Arabellastrasse 4
81925 München (DE)**

(54) **METHOD FOR REDUCING TRANSITION METAL, AND METHOD FOR TREATING SURFACE OF SILICON-CONTAINING POLYMER, METHOD FOR PREPARING FINE TRANSITION METAL PARTICLES AND METHOD FOR PRODUCING ARTICLE AND WIRING BOARD, USING THE REDUCING METHOD**

(57) The present invention is to provide a surface treating method for metallizing the surface of a polymer containing silicon by the use of a non-expensive material. Furthermore, this invention is to provide a method for metallizing the surface of or forming a pattern of a metal layer such as a wiring on the surface of a substrate comprising an arbitrary material, or a method for producing fine particles of a specific transition metal.

A method for treating the surface of a silicon-containing polymer or a method for preparing fine transition metal particles, **characterized in that** it comprises contacting an organosilicon compound with a solid, a solution or a suspension of a specific transition metal salt, to reduce and precipitate the transition metal and thereby precipitate fine particles of the transition metal on the surface of said organosilicon compound or in the organosilicon compound.

## Description

TECHNICAL FIELD

The present invention relates to a method for reducing a transition metal belonging to non-precious metals. More particularly, the invention relates to a method for preparing fine particles of the aforementioned transition metal which are needed for the production of electronic circuits or electronic parts for the applications to fine semiconductors of high density, electric household appliances or the like, or which are used for magnetic materials, magnetic parts or organic synthesis as catalysts, a surface treating method which gives conductivity to the surface of a substrate or which is to be a substrate for plating, and a metallizing method for forming a metal layer on the treated surface.

BACKGROUND ART

In late years, an organosilicon polymer represented by polysilane has been reviewed for the use as an electrically conductive material (Non-patent Document 1). Furthermore, polysilane is doped with a silver ion, whereby conductivity is enhanced (Patent Document 1) or it is weakly irradiated with light and then doped with a precious metal salt for an electroless plating (Patent Documents 2 and 3), whereby a metal thin film is formed on a substrate. Such methods have been under development. Further, there has been known a method comprising mixing a photo-oxidation radical generator on a polysilane thin film on a board and photo-patterning the polysilane layer using a photomask and removing polysiloxane in an exposed part by making it to be easily dissolved in an alkali solution (Patent Documents 4 to 7).

However, a method for plating by doping polysilane with a precious metal salt is limited in its applications because highly expensive precious metals are used. So, if it is possible to develop a method for making a relatively cheap metal to have a high conductivity and enabling patterning by irradiation with light, it is possible to form a drastically simplified wiring without requiring an electroless-plated catalyst, a resister or the like. Also, these electrically conductive materials using precious metals or silver in the past which are highly expensive are based on transition metals such as copper and the like so that it is possible to provide them with a low cost. However, such a method has not been developed. In Patent Document 2, there has been described that [salts of copper or nickel with a standard oxidation reduction potential lower than 0.54 V cannot be reduced to a silicon-containing polymer].

On the other hand, in late years, there have actively reviewed a method for forming fine transition metal particles or fine nano particles by reducing a transition metal ion with a reducing agent, and their applications. In Patent Document 8, fine Cu particles having a particle diameter of sub-micron have been obtained by reacting a copper carbonate solution with hydrazine. In Patent Document 9, an organic solvent extract of cobalt or nickel has been subjected to hydrogen reduction at 150°C or more in an autoclave to obtain fine particles of micron order. Further, in Patent Document 10, a dispersion obtained by dispersing iron oxide of $Fe_3O_4$ in a heat resistant liquid medium has been subjected to hydrogen reduction at high temperature and high pressure to obtain fine iron particles. These techniques employ a highly reactive reducing agent such as hydrogen, hydrazine or the like as a reducing agent. Further, a large majority of reductions have been carried out by heating. Therefore, it is necessary to pay attention when handling such a reducing agent and for that reason, there is a need to maintain equipment.

Further, even though the organosilicon compound can be a novel metal reducing agent which can be easily handled from the viewpoint of higher stability as compared to other reducing agents, the reaction of the organosilicon compound and metal salt has only been reported in a study (Non-patent Document 2) by Anderson et al. in 1958. In this document, the reaction for precipitating a metal is just a reduction reaction of copper salt by diethylsilane, while copper as a mixture with copper salt is only detected in a trace amount.

Patent Document 1: Japanese Patent Laid-open No. 1998-120907
Patent Document 2: Japanese Patent Laid-open No. 2002-105656
Patent Document 3: Japanese Patent Laid-open No. 1998-268521
Patent Document 4: Japanese Patent Laid-open No. 2002-356782
Patent Document 5: Japanese Patent Laid-open No. 1998-73925
Patent Document 6: Japanese Patent Laid-open No. 1995-114188
Patent Document 7: Japanese Patent Laid-open No. 1997-179305
Patent Document 8: Japanese Patent Laid-open No. 1998-317022
Patent Document 9: Japanese Patent No. 2818863
Patent Document 10: Japanese Patent Laid-open No. 1999-61206
Non-patent Document 1: [New Development for Organosilicon Materials Science], supervised by Hideki Sakurai, published by CMC Publishing Co., Ltd, 2001
Non-patent Document 2: Anderson et al. J. Am. Chem. Soc., Vol. 80, pp. 5083-5085 (1958)

## DISCLOSURE OF THE INVENTION

An object of the present invention is to provide a method for reducing a transition metal belonging to non-precious metals in an easy and safe manner, a method for preparing the above transition metal particles in an easier and safer method than the conventional method while the above fine transition metal particles have been particularly obtained by carrying out the reduction of the transition metal salt belonging to non-precious metal salts with a highly reactive reducing agent such as hydrogen, hydrazine or the like in the past, and a surface treating method for metallizing the surface of the silicon-containing polymer by using a non-expensive metal material. Further, this invention is to provide a method for metallizing the surface of a board or a three-dimensional object having an arbitrary material or an arbitrary shape or a method for forming a pattern of a metal layer such as wiring or the like.

In order to solve the above object, the present inventors have conducted an extensive study and as a result, have found that an organosilicon compound which is considered not capable of reducing the above transition metal salt can be reduced by selecting anions of the above transition metal salt. Further, they have found a method which can easily precipitate the above fine transition metal particles by using the reducibility of the organosilicon compound and a method for precipitating the above fine transition metal particles on the silicon-containing polymer or in the polymer. Further, it was found that the resulting material is plated to obtain an electrically conductive metal thin film, the above fine transition metal particles are generated on the non-exposed part by using a photomask prior to reacting a suspension of the above transition metal salt and partially irradiating with ultraviolet light and then heating, and an article having a patterned conductive layer is obtained by plating thereafter.

That is, the present invention relates to method for reducing a transition metal, which comprises contacting an organosilicon compound with a solution or a suspension of a transition metal salt to reduce and precipitate the transition metal, wherein the transition metal salt comprises a transition metal selected from the group consisting of copper, nickel, iron, cobalt, titanium, vanadium, zirconium, molybdenum, tungsten, chromium and manganese as a metal component, and counter anions capable of coordinating to silicon atoms.

Furthermore, the present invention relates to a method for forming fine particles of the above transition metal by reducing the transition metal using the above reduction method.

Also, the present invention relates to a method for treating a surface of a silicon-containing polymer, which comprises forming fine particles of the transition metal on the silicon-containing polymer or in the silicon-containing polymer by using the reduction method with a silicon-containing polymer as the organosilicon compound. The surface of the silicon-containing polymer on which fine particles of the above transition metal are formed may be further plated to form a metal layer.

Here, one of the preferred embodiments includes partially irradiating the silicon-containing polymer with light to form latent images on the silicon-containing polymer, and then heating, and then contacting the silicon-containing polymer with a solution or a suspension of said transition metal salt for reducing, thereby forming fine transition metal particles on the non-exposed part on the silicon-containing polymer or in the silicon-containing polymer. Further, a metal layer may be further formed on the non-exposed part by carrying out plating thereon. This silicon-containing polymer may be the organosilicon compound coated on a board or a three-dimensional object.

Further, the present invention relates to a method for preparing a wiring board obtained by carrying out plating after the surface treatment including a step of partially irradiating the silicon-containing polymer formed on the board with light using a negative mask according to wiring pattern. Or, a three-dimensional object having a metal layer patterned by plating after the same surface treatment on the three-dimensional object can be obtained.

Further, the present invention relates to a method for metallizing a substrate by carrying out one of the aforementioned surface treatments on the surface of the silicon-containing polymer formed on the substrate. Herein, the substrate refers to a board in a shape of a flat plate or a three-dimensional object.

Further, the present invention relates to an article comprising an organosilicon compound formed on its surface and further comprising fine transition metal particles formed on a surface of the organosilicon compound, and the article, wherein a metal plated layer is further formed on the surface of the silicon-containing polymer with the transition metal particles formed thereon.

The surface is subjected to a plating for metallizing it, whereby it is possible to give functions such as conductivity, decoration or the like. Even in a state that the above fine transition metal particles prior to being plated are precipitated, however, they may give an antistatic function or are useful as an intermediary product.

Counter anions of the transition metal salt capable of coordinating to silicon atoms of the organosilicon compound as described above have a Pauling's electronegativity of an atom in its anionic center preferably exceeding the value of Br (bromine).

According to the present invention, using an organosilicon compound which is easily handled as a reducing agent, fine particles of the above transition metal can be easily obtained. The obtained fine transition metal particles can also be used as a catalyst and the like in the organic reaction, in addition to metal materials and electronic materials of transition metal paste and the like. Furthermore, according to the present invention, a substrate is coated with a silicon-containing polymer and brought into contact with a solution or a suspension of the above transition metal salt, whereby the surface can be modified, and as needed metallized. Accordingly, the shape and material of the substrate are not particularly limited as far as it is a material capable of being coated with the silicon-containing polymer. Furthermore, a necessary place in the substrate is coated with a silicon-containing polymer or the unnecessary place thereof is exposed, whereby only the desired place thereof can be selectively surface-treated or metallized. Such surface treatment can give a conductivity or accordingly an antistatic function. Further, it is also possible to enhance the beautiful appearance in terms of decoration to an arbitrary object.

BEST MODE FOR CARRYING OUT THE INVENTION

A technique for reducing precious metal salt by the reducibility of polysilane to form precious metal colloid has been disclosed in Japanese Patent Laid-open No. 2002-105656. In the patent publication, there has been described that [salts of copper or nickel with a standard oxidation reduction potential lower than 0.54 V cannot be reduced with a silicon-containing polymer]. However, the present inventors have used various transition metal salts for doping and as a result, have found that by using salts in which counter anions of the transition metal salts are easily coordinated to silicon atoms of the silicon-containing polymer such as acetate ion or chloride ion, a highly reducible chemical species is formed and as a result, have found the reaction capable of reducing the transition metal salts with a low oxidation reduction potential.

One embodiment using this reduction method is generation of fine transition metal particles by the reduction. According to present invention, fine transition metal particles precipitated by mixing an organosilicon compound and transition metal salt are washed and taken out, whereby it is possible to easily obtain fine transition metal particles. A solid, a solution or a suspension of the organosilicon compound is mixed with a solid, a solution or a suspension of the transition metal salt and the mixture is reacted at room temperature or by heating, and then as needed washed to form fine transition metal particles. The reaction of the organosilicon compound and the transition metal salt may be carried out by a solid phase-solid phase reaction, a liquid phase-solid phase reaction, a solid phase-solution reaction or a solution-solution reaction. However, preferred is a solution-solution reaction because it is easy to handle and the reaction is rapidly carried out. The reaction is preferably carried out at room temperature.

The organosilicon compound may be a low molecular weight polymer or a high molecular weight polymer, and is preferably an organic compound having an Si-H bond or an Si-Si chain. More preferred are hydrosilanes, polyhydrosilanes or polysilanes having an Si-H bond or an Si-Si bond. As the polysilane having an Si-Si bond, methylphenyl polysilane (PhMeSi)n can be cited, while as the polysilane having an Si-H bond, phenyl polysilane (PhHSi) n can be cited. Further, the organosilicon compound may be used singly or in combination of a plurality of kinds. The organosilicon compound used in the present invention may be synthesized by the existing synthesis method or by a novel reaction.

According to present invention, transition metals or fine transition metal particles can be formed from transition metal salts by the reducibility of the organosilicon compound so that they can be applied to various materials. The transition metal salts may preferably have counter anions capable of coordinating to silicon atoms. Preferable examples thereof include one or more kinds selected from the group consisting of acetate salt, fluoride salt, chloride salt, carbonate salt, sulfate salt, nitrate salt, hydroxide salt, alcoholate salt, oxalate salt and carboxylate salt of transition metals. It is considered that a chemical species in which the silicon atom in the organosilicon compound is more highly reducible is created by using a metal salt having anions capable of coordinating to silicon. As a solvent of the above transition metal salt solution or suspension, a solvent which dissolves the transition metal salts in a certain amount and dissolves the silicon-containing polymer only in a small amount is preferable. Concrete examples thereof include acetonitrile, methanol, ethanol and 2-propanol.

Here, the above transition metal is selected from the group consisting of copper, nickel, iron, cobalt, titanium, vanadium, zirconium, molybdenum, tungsten, chromium and manganese. However, of these metals, copper, nickel, iron and cobalt are practically preferable. The amount of the transition metal salt used is usually from 1 to 1,000 mass parts and preferably from 10 to 300 mass parts, based on 100 mass parts of the organosilicon compound.

Another embodiment using the reduction is a method for forming fine particles of the transition metal on the silicon-containing polymer or in the silicon-containing polymer. These fine particles are grown to give a continuous film or the fine particles are plated to form a film having a required thickness. It is considered that the silicon-containing polymer has a capability to reduce the transition metal salt having anions capable of coordinating to silicon atoms alone to generate fine transition metal particles so that fine transition metal particles are generated on the silicon-containing polymer or in the polymer where can also be plated. In accordance with the TEM measurement, fine metal particles generated on the polymer were in a shape close to a flat circle having a width of from 0.05 to 1 $\mu$m and a thickness of from 0.01 to 0.1 $\mu$m or a little flat sphere having a diameter of from 0.01 to 0.2 $\mu$m.

Meanwhile, the fine transition metal particles can be selectively reduced and precipitated on the non-exposed part by the reducibility of the silicon-containing polymer of the non-exposed part and the loss of reducibility of the silicon-containing polymer of the exposed part. Using such a fact, the above fine transition metal particles can be selectively formed only on the non-exposed part on the silicon-containing polymer or in the polymer. Thereafter, it is demanded that electroless plating of the metal is carried out to form a plated layer having a thickness of from 0.01 to 20 μm. As needed, electrolytic plating may be carried out after electroless plating is carried out. By plating metals, it is possible to enhance decoration property or conductivity. Such fine particles can be applied to various materials.

Furthermore, the silicon-containing polymer thin film is irradiated with ultraviolet light through a photomask with wiring pattern formed thereon to form a part (non-exposed part) capable of reducing the above transition metal salt or a part (exposed part) incapable of reducing the above transition metal salt, and then immersed in a solution or a suspension of the above transition metal salt to selectively form a part with the above fine transition metal particles dispersed therein on the non-exposed part, where a patterned conductive body with a width of finely processed in a size of not more than 100 μm can be formed without using an expensive catalyst or resister. As a light source of the ultraviolet light used herein, a high pressure mercury lamp, a low pressure mercury lamp, a halogen lamp and the like are desired, though not restricted thereto.

In case of the irradiation with light on the silicon-containing polymer, it is preferable to heat the silicon-containing polymer after the irradiation with light. When the silicon-containing polymer is heated after the irradiation with light, the solvent solubility of the silicon-containing polymer is decreased by the crosslinking of the silicon-containing polymer, and the resolution is enhanced. Such effects are attained. When the heating temperature is too low, the solvent solubility of the silicon-containing polymer of the non-exposed part might be increased in some cases. When it is too high, the silicon-based polymer is decomposed. From such points, the heating temperature is demanded to be from 100°C to 250°C. On the other hand, when the whole surface of the silicon-containing polymer is metallized without irradiation with light, the heating step might be omitted, but in that case, in order to suppress the amount of the solvent dissolved into a solution or a suspension of the transition metal salt of the silicon polymer, the time required for the immersion in the transition metal salt solution or suspension is preferably shorter than the time required for a case where the temperature for heating or drying of the silicon polymer is heightened. In this case, since there is no pattern boundary, conditions making the pattern boundary unclear may be good. The dry temperature of the silicon-containing polymer coated on the substrate is demanded to be from 30 to 160°C in order to sufficiently dry the silicon polymer.

As the silicon-containing polymer, a compound having an Si-H bond or an Si-Si bond is preferred. Further, a compound having an Si-H bond is more preferred. These compounds have solvent-dissolving property for dissolving in an appropriate solvent in a small amount thereof. Furthermore, it is preferable that compounds generated before and after the irradiation with light have different reducibility. In this respect, polysilane or polycarbosilane having an Si-H bond or an Si-Si bond is more preferable. Further, polysilane or polycarbosilane having an Si-H bond is particularly preferable.

Furthermore, as polysilane, it is particularly preferable to use polysilane represented by the formula (1) singly or in mixture of different kinds in the formula (1).

$$(R1R2Si)n \quad ------ \quad Formula\ (1)$$

wherein, in the formula, R1 and R2 each independently represent a hydrogen atom, or a substituted or unsubstituted alkyl group, alkenyl group, alkyne group, aryl group and heterocyclic group; and n represents an integer of 5 to 100,000. It is further preferable that either of R1 and R2 is hydrogen. A weight average molecular weight of the silicon-containing polymer is not particularly limited as far as the silicon resin is soluble in a solvent and capable of forming a thin film on a substrate, but it is preferably in the range of 500 to 6,000,000 from the viewpoints of easiness of synthesis, solubility into a solvent, film-forming property and the like. These organosilicon compounds used in the present invention can be synthesized according to the existing synthesis method and demanded to be prepared in a nitrogen atmosphere of high purity. Further, the organosilicon compound may be used singly or in combination of a plurality of kinds.

A photo-radical generator may be added to the silicon-containing polymer. By adding the photo-radical generator, oxidation of the exposed part is accelerated and completed so that the boundary between the exposed part and the non-exposed part becomes sharp, thus enabling to enhance thinning. Preferable examples of the photo-radical generator include peroxide, peroxy acid, peroxy acid ester, 1,3,5-triazines, amine oxides, phosphine oxides, sulfine oxides, sulfones, azo compounds and the like. Of these, particularly preferred are peroxide, peroxy acid and peroxy acid ester capable of oxidizing the light irradiated portion by generating oxide radical by irradiation with light. By the selection of the photo-radical generator, photo-oxidation wavelength of the silicon-containing polymer mixture can also be changed. The amount of the photo-radical generator used is not particularly limited and can be properly selected from a wide range, but it is preferably from 0.5 to 100 weight parts, based on 100 weight parts of the silicon-based polymer.

Preferable examples of the transition metal salt include one or more kinds selected from the group consisting of acetate salt, fluoride salt, chloride salt, carbonate salt, sulfate salt, nitrate salt, hydroxide salt, alcoholate salt, oxalate salt and carboxylate salt of the above transition metal. The amount of the transition metal salt is usually from 1 to 1,000 weight parts and preferably from 1 to 100 weight parts, based on 100 weight parts of the silicon-containing polymer. As a solvent of the above transition metal salt solution or suspension, a solvent which dissolves the transition metal salt in a certain amount and dissolves the silicon-containing polymer only in a small amount is preferable. Concrete examples thereof include acetonitrile, methanol, ethanol and 2-propanol. Here, the above transition metal is selected from the group consisting of copper, nickel, iron, cobalt, titanium, vanadium, zirconium, molybdenum, tungsten, chromium and manganese, but particularly preferred are copper, nickel, iron and cobalt which are relatively cheap and can be used for various applications.

Examples of plating include electroless copper plating, electroless nickel plating and the like. Thereafter, electrolytic copper plating, electrolytic nickel plating, electrolytic silver plating, electrolytic gold plating and the like may be carried out. Plating may be carried out with metals different from the above fine transition metal particles which are generated by the reduction.

As a method for forming a thin film of the silicon-based polymer on a board or an object that is a substrate, a method including preparing a solution of the silicon-containing polymer, coating the resulting solution on the substrate, and then vaporizing in a solvent at normal pressure or reduced pressure at room temperature or by heating to obtain a thin film can be cited. The dry temperature at this time is preferably in the range of 30°C to 160°C.

The material of a substrate is not particularly limited as far as it can be coated with a silicon-containing polymer, but preferable examples thereof include glass, quartz, polyimide, silicon and glass epoxy resin which have achievements in various applications. Plates or three-dimensional objects composed of these materials are suitable. Further, since the solution of the silicon-containing polymer can be coated on objects of arbitrary shapes, a wiring board such as a flexible board, a multi-layered board, a build-up board or the like, a non-flat package for loading a photoelectronic device or a semiconductor device, a board requiring wiring of a large-sized equipment for such as a solar cell, for various displays and the like, a board requiring high density fine wiring for such as medical equipment, and a board requiring wiring for forming MEMS of micro machinings can be made into a substrate. Further, a silicon-containing polymer film formed on a substrate may be peeled away from the substrate and also used in a shape of a film or a sheet. Further, the silicon polymer solution may be coated on the whole surface of the surface desired for the surface treatment of the substrate or coated only on the place requiring wiring of the through-hole part of the wiring board or the substrates as cited above.

In the preparation of a printed wiring board, a silicon-containing polymer layer is formed on a substrate composed of the printed wiring board and irradiated with ultraviolet light through a photomask with a pattern corresponding to the wiring pattern formed thereon. Next, when the resulting material is heated preferably at 100°C to 250°C and immersed in a solution or a suspension of the fine transition metal particles, the fine transition metal particles are not generated on the light irradiated part (exposed part), while the above fine transition metal particles are formed only on the non-exposed part. If this silicon-containing polymer is subjected to a metal electroless plating, the metal is precipitated only on the non-exposed part to obtain a metal wiring pattern. At this time, when the through-hole is previously formed on the substrate, the silicon-containing polymer layer is also formed inside the through-hole. If the through-hole is not irradiated with light with the photomask, the inside of the through-hole is also metal-plated so that the surface and back surface of the wiring board can be electrically connected. In this case, the material of the substrate can also be selected from a wide range of materials. A glass epoxy board or a polyimide board which has been used as a wiring board in the past is suitably used. Furthermore, by carrying out the same treatment to three-dimensional objects, a package for loading a photoelectronic device or a package for loading a semiconductor device, which is at least equipped a wiring pattern at an outer surface, is obtained as a three-dimensional object.

Other three-dimensional objects are used as substrates and the silicon-containing polymer layer is coated and formed on the whole surface or a place requiring metallization. The resulting material is immersed in a solution of the transition metal salt or the like to precipitate the fine transition metal particles on the whole surface of the silicon-containing polymer and plating is carried out thereon, whereby a surface-metallized three-dimensional object is obtained. In this case, the material of the substrate may be good as far as it can be coated with the silicon-containing polymer, and can be selected from a wide range of materials.

Preferred examples of the article obtained by the present invention include, though not restricted to, electronic parts such as wiring boards, electronic devices, photodiodes, packages for loading electronic devices or optical devices, electronic shielding materials or the like, optical parts, magnetic parts or magnetic materials such as electronic materials, antennas, motors, induction elements or the like, structures of micro machinings, ornaments in metal color and the like.

The present invention is now more specifically illustrated below with reference to Examples. However, the present invention is not restricted to these Examples. In these Examples and Comparative Examples, all part(s) hereinafter indicates mass part (s), while values of physical properties are measured at 25°C. The silicon-containing polymer used in the present invention can be synthesized by the existing synthesis method such as the Wurz method, the metallocene method and the like. Further, as a plating bath of electroless copper plating in respective Examples and Comparative Examples, an ATS Atcopper solution, a product of Okuno Chemical Industries Co., Ltd. was used.

(Example 1)

1 part of (C$_6$H$_5$SiH)n (in Formula (1), R1=C$_6$H$_5$, R2=H; hereinafter referred to as (PhHSi)n) was dissolved in 9 parts of toluene. The resulting solution was coated on a glass board by spin coating (500 rpm, 20 seconds) and vacuum-dried at 150 °C for 1 hour to form a polysilane film on the board. n was 30 to 100. This board was not exposed to ultraviolet light, immersed in a solution obtained by suspending 1 part of copper (I) acetate in 99 parts of acetonitrile at room temperature in a nitrogen atmosphere for 5 minutes while stirring, washed with acetonitrile for 10 seconds, and dried in a nitrogen flow for 5 minutes. At this time, fine metal particles were precipitated on a surface of the polysilane film and around it. The fine metal particles precipitated on the polymer were analyzed and turned out to be fine particles of copper, and sizes thereof were measured by TEM and as a result, most of fine particles were in a shape of a little flat sphere with the sizes in the range of 0.05 to 0.1 $\mu$m. This substrate was subjected to an electroless copper plating for 30 minutes, whereby a board with an electrically conductive copper layer formed all over the whole surface was prepared. The thickness of the formed copper layer was about 0.1 $\mu$m.

(Example 2)

1 part of (PhHSi)n was dissolved in 9 parts of toluene. The resulting solution was coated on a glass board by spin coating (500 rpm, 20 seconds) and vacuum-dried at 60°C for 1 hour to form a polysilane film on the board. n was 30 to 100. This board was not exposed to ultraviolet light, immersed in a solution obtained by suspending 1 part of copper (I) acetate in 99 parts of acetonitrile at room temperature in a nitrogen atmosphere for 2 minutes while stirring, washed with acetonitrile for 10 seconds, and dried in a nitrogen flow for 5 minutes. As a result of observation after drying, the same , color as in Example 1 was confirmed. This substrate was subjected to an electroless copper plating for 30 minutes, whereby a board with an electrically conductive copper layer formed all over the whole surface was prepared. The thickness of the formed copper layer was about 0.1 $\mu$m.

(Example 3)

1 part of (PhHSi)n was dissolved in 9 parts of toluene. The resulting solution was coated on a glass epoxy board by spin coating (500 rpm, 20 seconds) and vacuum-dried at 60°C for 1 hour to form a polysilane film on the board. n was 30 to 100. This substrate was irradiated with ultraviolet light at 254 nm of 1.2 J/cm$^2$ using a stripe patterned photomask at a width of 100 $\mu$m and at intervals of 100 $\mu$m to form latent images on polysilane on the board. After irradiation with light, the board was heated at 170°C under reduced pressure for 1 hour. Next, this substrate was immersed in a solution obtained by suspending 0.3 part of copper (I) acetate in 99.7 parts of acetonitrile at room temperature in a nitrogen atmosphere for 5 minutes while stirring, washed with acetonitrile for 10 seconds, and dried in a nitrogen flow for 5 minutes. As a result of observation after drying, the same color as in Example 1 was confirmed in the non-exposed part. This substrate was subjected to an electroless copper plating for 30 minutes, whereby a copper layer was formed only on the non-exposed part to prepare a wiring board with an electrically conductive copper layer in a shape of stripe. The thickness of the copper layer formed on the non-exposed part was about 0.1 $\mu$m.

(Example 4)

The heating temperature after irradiation with light was set to 150°C and the other conditions were the same as those in Example 3. The same stripe pattern in a copper layer was obtained, but the stripe pattern did not have sharp edges.

(Example 5)

An experiment was carried out in the same manner as in Example 3 by setting the heating temperature after irradiation with light to 200°C. As a result, the same results as in Example 3 were obtained.

(Example 6)

1 part of (PhHSi)n was dissolved in 9 parts of toluene. The resulting solution was coated on a glass epoxy board by spin coating (500 rpm, 20 seconds) and vacuum-dried at 60°C for 1 hour to form a polysilane film on the board. n was 30 to 100. This substrate was irradiated with ultraviolet light at 254 nm of 1.2 J/cm$^2$ using a stripe patterned photomask at a width of 100 $\mu$m and at intervals of 100 $\mu$m to form latent images on polysilane on the board. After irradiation with light, the board was heated at 170°C under reduced pressure for 1 hour. Next, this substrate was immersed in a solution obtained by suspending 0.3 part of copper (I) chloride in 99.7 parts of acetonitrile at room temperature in a nitrogen atmosphere for 5 minutes while stirring, washed with acetonitrile for 10 seconds, and dried in a nitrogen flow for 5 minutes. As a result of observation after drying, the same color as in Example 1 was confirmed in the non-exposed part. This substrate was subjected to an electroless copper plating for 30 minutes, whereby a copper layer was formed only on the non-exposed part to prepare a wiring board with an electrically conductive copper layer in a shape of stripe. The thickness of the copper layer formed on the non-exposed part was about 0.1 $\mu$m.

(Example 7)

1 part of (PhHSi)n was dissolved in 9 parts of toluene. The resulting solution was coated on a glass epoxy board by spin coating (500 rpm, 20 seconds) and vacuum-dried at 60°C for 1 hour to form a polysilane film on the board. n was 30 to 100. This substrate was irradiated with ultraviolet light at 254 nm of 1.2 J/cm$^2$ using a stripe patterned photomask at a width of 100 $\mu$m and at intervals of 100 $\mu$m to form latent images on polysilane on the board. After irradiation with light, the board was heated at 170°C under reduced pressure for 1 hour. Next, this substrate was immersed in a solution obtained by suspending 0.3 part of copper (I) ethoxide in 99.7 parts of acetonitrile at room temperature in a nitrogen atmosphere for 5 minutes while stirring, washed with acetonitrile for 10 seconds, and dried in a nitrogen flow for 5 minutes. As a result of observation after drying, the same color as in Example 1 was confirmed in the non-exposed part. This substrate was subjected to an electroless copper plating for 30 minutes, whereby a copper layer was formed only on the non-exposed part to prepare a wiring board with an electrically conductive copper layer in a shape of stripe. The thickness of the copper layer formed on the non-exposed part was about 0.1 $\mu$m.

(Example 8)

1 part of (PhHSi)n was dissolved in 9 parts of toluene. The resulting solution was coated on a glass epoxy board by spin coating (500 rpm, 20 seconds) and vacuum-dried at 60°C for 1 hour to form a polysilane film on the board. n was 30 to 100. This substrate was irradiated with ultraviolet light at 254 nm of 1.2 J/cm$^2$ using a stripe patterned photomask at a width of 100 $\mu$m and at intervals of 100 $\mu$m to form latent images on polysilane on the board. After irradiation with light, the board was heated at 170°C under reduced pressure for 1 hour. Next, this substrate was immersed in a solution obtained by suspending 0.3 part of copper (I) oxalate in 99.7 parts of acetonitrile at room temperature in a nitrogen atmosphere for 5 minutes while stirring, washed with acetonitrile for 10 seconds, and dried in a nitrogen flow for 5 minutes. As a result of observation after drying, the same color as in Example 1 was confirmed in the non-exposed part. This substrate was subjected to an electroless copper plating for 30 minutes, whereby a copper layer was formed only on the non-exposed part to prepare a wiring board with an electrically conductive copper layer in a shape of stripe. The thickness of the copper layer formed on the non-exposed part was about 0.1 $\mu$m.

(Example 9)

1 part of (PhHSi)n was dissolved in 9 parts of toluene. The resulting solution was coated on a glass epoxy board by spin coating (500 rpm, 20 seconds) and vacuum-dried at 60°C for 1 hour to form a polysilane film on the board. n was 30 to 100. This substrate was irradiated with ultraviolet light at 254 nm of 1.2 J/cm$^2$ using a stripe patterned photomask at a width of 100 $\mu$m and at intervals of 100 $\mu$m to form latent images on polysilane on the board. After irradiation with light, the board was heated at 170°C under reduced pressure for 1 hour. Next, this substrate was immersed in a solution obtained by suspending 0.3 part of copper (I) carbonate in 99.7 parts of acetonitrile at room temperature in a nitrogen atmosphere for 5 minutes while stirring, washed with acetonitrile for 10 seconds, and dried in a nitrogen flow for 5 minutes. As a result of observation after drying, the same color as in Example 1 was confirmed in the non-exposed part. This substrate was subjected to an electroless copper plating for 30 minutes, whereby a copper layer was formed only on the non-exposed part to prepare a wiring board with an electrically conductive copper layer in a shape of stripe. The thickness of the copper layer formed on the non-exposed part was about 0.1 $\mu$m.

(Example 10)

1 part of p-anisyl hydropolysilane (in Formula (1), R1=-Ph-p-OCH$_3$, wherein Ph=phenylene group; and R2=H) was dissolved in 9 parts of toluene. The resulting solution was coated on a glass epoxy board by spin coating (500 rpm, 20 seconds) and vacuum-dried at 60°C for 1 hour to form a polysilane film on the board. n was 30 to 100. This substrate was irradiated with ultraviolet light at 254 nm of 1.2 J/cm$^2$ using a stripe patterned photomask at a width of 100 $\mu$m and at intervals of 100 $\mu$m to form latent images on polysilane on the board. After irradiation with light, the board was heated at 170°C under reduced pressure for 1 hour. Next, this substrate was immersed in a solution obtained by suspending 0.3 part of copper (I) acetate in 99.7 parts of acetonitrile at room temperature in a nitrogen atmosphere for 5 minutes while stirring, washed with acetonitrile for 10 seconds, and dried in a nitrogen flow for 5 minutes. As a result of observation after drying, the same color as in Example 1 was confirmed in the non-exposed part. This substrate was subjected to an electroless copper plating for 30 minutes, whereby a copper layer was formed only on the non-exposed part to prepare a wiring board with an electrically conductive copper layer in a shape of stripe. The thickness of the copper layer formed on the non-exposed part was about 0.1 $\mu$m.

(Example 11)

1 part of p-anisyl hydropolysilane was dissolved in 9 parts of toluene. The resulting solution was coated on a glass epoxy board by spin coating (500 rpm, 20 seconds) and vacuum-dried at 60°C for 1 hour to form a polysilane film on the board. n was 30 to 100. This substrate was irradiated with ultraviolet light at 254 nm of 1.2 J/cm$^2$ using a stripe patterned photomask at a width of 100 $\mu$m and at intervals of 100 $\mu$m to form latent images on polysilane on the board. After irradiation with light, the board was heated at 170°C under reduced pressure for 1 hour. Next, this substrate was immersed in a solution obtained by suspending 0.3 part of copper (I) chloride in 99.7 parts of acetonitrile at room temperature in a nitrogen atmosphere for 5 minutes while stirring, washed with acetonitrile for 10 seconds, and dried in a nitrogen flow for 5 minutes. As a result of observation after drying, the same color as in Example 1 was confirmed in the non-exposed part. This substrate was subjected to an electroless copper plating for 30 minutes, whereby a copper layer was formed only on the non-exposed part to prepare a wiring board with an electrically conductive copper layer in a shape of stripe. The thickness of the copper layer formed on the non-exposed part was about 0.1 $\mu$m.

(Example 12)

1 part of p-anisyl hydropolysilane was dissolved in 9 parts of toluene. The resulting solution was coated on a glass epoxy board by spin coating (500 rpm, 20 seconds) and vacuum-dried at 60°C for 1 hour to form a polysilane film on the board. n was 30 to 100. This substrate was irradiated with ultraviolet light at 254 nm of 1.2 J/cm$^2$ using a stripe patterned photomask at a width of 100 $\mu$m and at intervals of 100 $\mu$m to form latent images on polysilane on the board. After irradiation with light, the board was heated at 170°C under reduced pressure for 1 hour. Next, this substrate was immersed in a solution obtained by suspending 0.3 part of copper (I) ethoxide in 99.7 parts of acetonitrile at room temperature in a nitrogen atmosphere for 5 minutes while stirring, washed with acetonitrile for 10 seconds, and dried in a nitrogen flow for 5 minutes. As a result of observation after drying, the same color as in Example 1 was confirmed in the non-exposed part. This substrate was subjected to an electroless copper plating for 30 minutes, whereby a copper layer was formed only on the non-exposed part to prepare a wiring board with an electrically conductive copper layer in a shape of stripe. The thickness of the copper layer formed on the non-exposed part was about 0.1 $\mu$m.

(Example 13)

1 part of p-anisyl hydropolysilane was dissolved in 9 parts of toluene. The resulting solution was coated on a glass epoxy board by spin coating (500 rpm, 20 seconds) and vacuum-dried at 60°C for 1 hour to form a polysilane film on the board. n was 30 to 100. This substrate was irradiated with ultraviolet light at 254 nm of 1.2 J/cm$^2$ using a stripe patterned photomask at a width of 100 $\mu$m and at intervals of 100 $\mu$m to form latent images on polysilane on the board. After irradiation with light, the board was heated at 170°C under reduced pressure for 1 hour. Next, this substrate was immersed in a solution obtained by suspending 0.3 part of copper (I) oxalate in 99.7 parts of acetonitrile at room temperature in a nitrogen atmosphere for 5 minutes while stirring, washed with acetonitrile for 10 seconds, and dried in a nitrogen flow for 5 minutes. As a result of observation after drying, the same color as in Example 1 was confirmed in the non-exposed part. This substrate was subjected to an electroless copper plating for 30 minutes, whereby a copper layer was formed only on the non-exposed part to prepare a wiring board with an electrically conductive copper layer in a shape of stripe. The thickness of the copper layer formed on the non-exposed part was about 0.1 $\mu$m.

(Example 14)

1 part of p-anisyl hydropolysilane was dissolved in 9 parts of toluene. The resulting solution was coated on a glass epoxy board by spin coating (500 rpm, 20 seconds) and vacuum-dried at 60°C for 1 hour to form a polysilane film on the board. n was 30 to 100. This substrate was irradiated with ultraviolet light at 254 nm of 1.2 J/cm$^2$ using a stripe patterned photomask at a width of 100 $\mu$m and at intervals of 100 $\mu$m to form latent images on polysilane on the board. After irradiation with light, the board was heated at 170°C under reduced pressure for 1 hour. Next, this substrate was immersed in a solution obtained by suspending 0.3 part of copper (I) carbonate in 99.7 parts of acetonitrile at room temperature in a nitrogen atmosphere for 5 minutes while stirring, washed with acetonitrile for 10 seconds, and dried in a nitrogen flow for 5 minutes. As a result of observation after drying, the same color as in Example 1 was confirmed in the non-exposed part. This substrate was subjected to an electroless copper plating for 30 minutes, whereby a copper layer was formed only on the non-exposed part to prepare a wiring board with an electrically conductive copper layer in a shape of stripe. The thickness of the copper layer formed on the non-exposed part was about 0.1 $\mu$m.

(Example 15)

1 part of hydro(2-thienyl)polysilane (in Formula (1), R1=2-thienyl, R2=H) was dissolved in 9 parts of toluene. The resulting solution was coated on a glass epoxy board by spin coating (500 rpm, 20 seconds) and vacuum-dried at 60°C for 1 hour to form a polysilane film on the board. n was 30 to 100. This substrate was irradiated with ultraviolet light at 254 nm of 1.2 J/cm$^2$ using a stripe patterned photomask at a width of 100 $\mu$m and at intervals of 100 $\mu$m to form latent images on polysilane on the board. After irradiation with light, the board was heated at 170°C under reduced pressure for 1 hour. Next, this substrate was immersed in a solution obtained by suspending 0.3 part of copper (I) carbonate in 99.7 parts of acetonitrile at room temperature in a nitrogen atmosphere for 5 minutes while stirring, washed with acetonitrile for 10 seconds, and dried in a nitrogen flow for 5 minutes. As a result of observation after drying, the same color as in Example 1 was confirmed in the non-exposed part. This substrate was subjected to an electroless copper plating for 30 minutes, whereby a copper layer was formed only on the non-exposed part to prepare a wiring board with an electrically conductive copper layer in a shape of stripe. The thickness of the copper layer formed on the non-exposed part was about 0.1 $\mu$m.

(Example 16)

10 parts of (PhHSi)n and 1 part of 3,3',4,4'-tetra(t-butylperoxycarbonyl)benzophenone as a photo-radical generator were dissolved in 100 parts of toluene. The resulting solution was coated on a glass board by spin coating (1, 500 rpm, 20 seconds) and vacuum-dried at 60°C to form a polysilane film on the board. n was 30 to 100. This substrate was irradiated with ultraviolet light at 365 nm of 1.2 J/cm$^2$ using a stripe patterned photomask at a width of 100 $\mu$m and at intervals of 100 $\mu$m to form latent images on polysilane on the board. This substrate was vacuum-dried at 150°C for 1 hour, cooled down, and then immersed in a suspension with 1 part of copper (I) acetate dissolved in 99 parts of acetonitrile at room temperature in a nitrogen atmosphere for 5 minutes while stirring, further washed with acetonitrile for 10 seconds, and dried in a nitrogen flow for 5 minutes. As a result of observation after drying, the same color as in Example 1 was confirmed in the non-exposed part. The fine metal particles precipitated on the non-exposed part were analyzed and turned out to be fine particles of copper, and sizes thereof were measured by TEM and as a result, most of fine particles were in a shape of a little flat sphere with the sizes in the range of 0.05 to 0.1 $\mu$m. Further, this substrate was subjected to an electroless copper plating for 30 minutes, whereby a copper layer was formed only on the non-exposed part to prepare a wiring board with an electrically conductive copper layer in a shape of stripe. The thickness of the copper layer formed on the non-exposed part was 0.1 $\mu$m.

(Example 17)

10 parts of (PhHSi)n and 1 part of 3,3',4,4'-tetra(t-butylperoxycarbonyl)benzophenone as a photo-radical generator were dissolved in 100 parts of toluene. The resulting solution was coated on a glass board by spin coating (1,500 rpm, 20 seconds) and vacuum-dried at 60°C to form a polysilane film on the board. n was 30 to 100. This substrate was irradiated with ultraviolet light at 365 nm of 1.2 J/cm$^2$ using a stripe patterned photomask at a width of 100 $\mu$m and at intervals of 100 $\mu$m to form latent images on polysilane on the board. This substrate was vacuum-dried at 120°C for 1 hour, cooled down, and then immersed in a suspension with 1 part of copper (I) acetate dissolved in 99 parts of acetonitrile at room temperature in a nitrogen atmosphere for 5 minutes while stirring, further washed with acetonitrile for 10 seconds, and dried in a nitrogen flow for 5 minutes. As a result of observation after drying, the same color as in Example 1 was confirmed in the non-exposed part. Further, this substrate was subjected to an electroless copper plating for 30 minutes, whereby a copper layer was formed only on the non-exposed part to prepare a wiring board with an electrically conductive copper layer in a shape of stripe. The thickness of the copper layer formed on the non-exposed part was 0.1 $\mu$m.

(Example 18)

40 parts of (PhHSi)n having a molecular weight of 3,000 to 10,000 was dispersed in 990 parts of acetonitrile, while on the other hand 17 parts of copper (I) acetate Cu(OCOCH$_3$) was dispersed in 990 parts of acetonitrile. N was 30 to 100. These two solutions were mixed at room temperature in a nitrogen atmosphere. After removing a supernatant liquid, the precipitated solid was washed with acetonitrile at room temperature, and then dried at 60°C under reduced pressure for 30 minutes, measured by XRD and as a result, only the peak of copper was observed. Metal copper generated by reduction was 8 parts, while the sizes of particles were from 1 to 10 $\mu$m. The sizes of particles were obtained by using an optical microscope.

(Example 19)

46 parts of PhSiH$_3$ was dissolved in 990 parts of acetonitrile, while on the other hand 28 parts of copper (I) acetate Cu(OCOCH$_3$) was dispersed in 990 parts of acetonitrile. These two solutions were mixed at room temperature in a nitrogen atmosphere. After removing a supernatant liquid, the precipitated solid was washed with acetonitrile at room temperature, dried at 60 under reduced pressure for 30 minutes, measured by XRD and as a result, only the peak of copper was observed. Metal copper generated by reduction was 14 parts, while the sizes of particles were from 1 to 10 $\mu$m.

(Example 20)

14 parts of PhSiH$_3$ was dissolved in 390 parts of acetonitrile, while on the other hand 6 parts of copper (II) acetate Cu(OCOCH$_3$)$_2$ was dissolved in 390 parts of acetonitrile. These two solutions were mixed at room temperature in an air. After removing a supernatant liquid, the precipitated solid was washed with acetonitrile at room temperature, dried at 60°C under reduced pressure for 30 minutes, measured by XRD and as a result, only the peak of copper was observed. Metal copper generated by reduction was 2 parts, while the sizes of particles were from 1 to 10 $\mu$m.

(Comparative Example 1)

As in Example 3, 1 part of (PhHSi)n was dissolved in 9 parts of toluene. The resulting solution was coated on a glass board by spin coating (500 rpm, 20 seconds) and vacuum-dried at 60°C for 1 hour to form a polysilane film on the board. n was 30 to 100. This substrate was irradiated with ultraviolet light at 254 nm of 1.2 J/cm$^2$ using a stripe patterned photomask to form latent images on polysilane on the board. Next, this substrate was immersed in a solution obtained by suspending 1 part of copper (I) bromide in 99 parts of acetonitrile at room temperature in a nitrogen atmosphere for 5 minutes while stirring, washed with acetonitrile for 10 seconds, and dried in a nitrogen flow for 5 minutes. In this case, the color of the reduced fine copper particles was not observed. Even though this substrate was subjected to an electroless copper plating for 30 minutes, it was not possible to form a plated film.

(Comparative Example 2)

1 part of (PhHSi)n was dissolved in 9 parts of toluene. The resulting solution was coated on a glass board by spin coating (500 rpm, 20 seconds) and vacuum-dried at 60°C for 1 hour to form a polysilane film on the board. n was 30 to 100. This substrate was irradiated with ultraviolet light at 254 nm of 1.2 J/cm$^2$ using a stripe patterned photomask to form latent images on polysilane on the board and heated at 170°C. Next, this substrate was immersed in a solution obtained by suspending 1 part of copper (I) bromide in 99 parts of acetonitrile at room temperature in a nitrogen atmosphere for 5 minutes while stirring, washed with acetonitrile for 1.0 seconds, and dried in a nitrogen flow for 5 minutes. In this case, the color of the reduced fine copper particles was not observed. Even though this substrate was subjected to an electroless copper plating for 30 minutes, it was not possible to form a plated film.

INDUSTRIAL APPLICABILITY

The present invention is applicable to preparation of electrically conductive materials used for wiring of large-sized equipment such as solar cells, various displays and the like, electronic materials such as circuit boards, semiconductor substrates and the like, electromagnetic shield materials, robots, information electric household appliances, cellular phones and portable equipment. This invention is also applicable to fine wiring of parts of vehicles or motors and medical appliances for checkup, treatment and the like of internal organs, wiring for connecting a structure of a micro machining, a so-called MEMS, or metallization and the like, in addition to the wide range of applications in electrical field, electronic field and telecommunication field. Further, when transition metals having magnetism are used, the present invention can also be applied as magnetic materials. Besides, this invention can also be applied to preparation of an ornament with a metal layer formed on its surface.

**Claims**

1. A method for reducing a transition metal, which comprises contacting an organosilicon compound with a solid, a solution or a suspension of a transition metal salt to reduce and precipitate the transition metal,
   wherein the transition metal salt comprises a transition metal selected from the group consisting of copper, nickel, iron, cobalt, titanium, vanadium, zirconium, molybdenum, tungsten, chromium and manganese as a metal component

and counter anions capable of coordinating to silicon atoms.

2. The method for reducing a transition metal as set forth in claim 1, wherein the transition metal salt is one or more kinds selected from the group consisting of acetate salt, fluoride salt, chloride salt, carbonate salt, sulfate salt, nitrate salt, hydroxide salt, alcoholate salt, oxalate salt and carboxylate salt of the transition metal.

3. A method for preparing fine transition metal particles, which comprises forming fine particles of the transition metal by using the reduction method as set forth in claim 1 or 2.

4. A method for treating a surface of a silicon-containing polymer, which comprises forming fine particles of the transition metal on the silicon-containing polymer or in the silicon-containing polymer by using the reduction method as set forth in claim 1 or 2 wherein the organosilicon compound is a silicon-containing polymer.

5. The method for treating a surface of a silicon-containing polymer as set forth in claim 4, which comprises partially irradiating the silicon-containing polymer with light, and then heating, and then contacting the silicon-containing polymer with a solution or a suspension of said transition metal salt to reduce and precipitate fine transition metal particles on the non-exposed part on the silicon-containing polymer or in the silicon-containing polymer.

6. A method for metallizing a surface of a board or a three-dimensional object, which comprises forming a silicon-containing polymer on a board or a three-dimensional object and carrying out the surface treatment as set forth in claim 4 or 5 on a surface of the silicon-containing polymer.

7. A method for preparing a wiring board, which comprises forming a silicon-containing polymer on a board, carrying out the surface treatment as set forth in claim 5 on a surface of the silicon-containing polymer, and then carrying out a metal plating to precipitate a plated metal composed of a conductive layer on the non-exposed part.

8. A method for preparing a three-dimensional object, which comprises forming a silicon-containing polymer on a three-dimensional object, carrying out the surface treatment as set forth in claim 4 or 5 on a surface of the silicon-containing polymer, and then carrying out a metal plating to precipitate a plated metal on the non-exposed part.

9. An article comprising an organosilicon compound formed on its surface and further comprising fine transition metal particles formed on a surface of the organosilicon compound.

10. The article as set forth in claim 9, wherein a metal plated layer is further formed on the surface of the organosilicon compound with the transition metal particles formed thereon.

| INTERNATIONAL SEARCH REPORT | International application No. |
|---|---|
| | PCT/JP2005/021446 |

A. CLASSIFICATION OF SUBJECT MATTER
*C23C18/31*(2006.01), *C23C18/20*(2006.01), *B22F9/18*(2006.01)

According to International Patent Classification (IPC) or to both national classification and IPC

B. FIELDS SEARCHED

Minimum documentation searched (classification system followed by classification symbols)
C23C18/00-20/08, C23C24/00-30/00, B22F9/00-9/30, B29D9/00, B32B1/00-35/00

| Documentation searched other than minimum documentation to the extent that such documents are included in the fields searched | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X <br> Y | JP 64-062475 A (Shiseido Co., Ltd.), <br> 08 March, 1989 (08.03.89), <br> Page 3, upper left column, line 1 to <br> page 11, upper right column, line 18 <br> (Family: none) | 9,10 <br> 1-4,6 |
| X <br> Y | JP 2002-133948 A (Shin-Etsu Chemical Co., <br> Ltd.), <br> 10 May, 2002 (10.05.02), <br> Par. Nos. [0009] to [0078] <br> (Family: none) | 9,10 <br> 1-4,6 |
| X <br> Y | JP 11-271981 A (Shin-Etsu Chemical Co., Ltd.), <br> 08 October, 1999 (08.10.99), <br> Par. Nos. [0006] to [0040] <br> (Family: none) | 9 <br> 1-8 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 14 February, 2006 (14.02.06) | 21 February, 2006 (21.02.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.

PCT/JP2005/021446

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2004-115839 A (Waseda University), 15 April, 2004 (15.04.04), Par. Nos. [0009] to [0016] (Family: none) | 1-8 |
| A | JP 10-317022 A (Daiken Chemical Co., Ltd.), 02 December, 1998 (02.12.98), Full text (Family: none) | 1-10 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10120907 A
- JP 2002105656 A
- JP 10268521 A
- JP 2002356782 A
- JP 10073925 A
- JP 7114188 A
- JP 9179305 A
- JP 10317022 A
- JP 2818863 B
- JP 11061206 A

**Non-patent literature cited in the description**

- New Development for Organosilicon Materials Science. CMC Publishing Co., Ltd, 2001
- **ANDERSON et al.** *J. Am. Chem. Soc.,* 1958, vol. 80, 5083-5085